# EUROPEAN PATENT APPLICATION

(11) **EP 3 499 597 A1**
(43) Date of publication of application: **19.06.2019**
(21) Application number: 17207871.9
(22) Date of filing: 15.12.2017
(51) Int. Cl.: H01L 51/42

(54) **ELECTRON SPECIFIC OXIDE DOUBLE LAYER CONTACTS FOR HIGHLY EFFICIENT AND UV STABLE PEROVSKITE DEVICE**

(71) Applicant: Ecole Polytechnique Fédérale de Lausanne (EPFL), 1015 Lausanne (CH)
(72) Inventor: Tavakoli, Mohammad Mahdi, Cambridge, MA 02141 (US); Zakeeruddin, Shaik Mohammed, 1030 Bussigny (CH); Graetzel, Michael, 1025 St-Sulpice (CH)
(74) Representative: Ganguillet, Cyril

(57) **Abstract**

The present invention relates to an optoelectronic and/or photovoltaic device comprising an electron transport layer (ETL) and a light harvesting layer, wherein the light harvesting layer comprises a metal halide perovskite; and said ETL comprises one or more layers of metal oxide, the layer being in contact with said light harvesting layer comprising a metal oxide being in amorphous state

## Description

### Technical Field

This invention relates to a photovoltaic device, in particular to metal organohalide perovskite photovoltaic device, to metal organohalide perovskite solar cells (PSCs), a method for producing photovoltaic devices, and more specifically, to a method for producing organic-inorganic perovskite based photovoltaic devices having an amorphous inorganic semiconductor layer.

### Prior Art and the Problem Underlying the Invention

Recently, in order to tackle energy problem and find a new source of clean energy, various researches for energy have been progressed to replace existing fossil fuels. Energy plays a key role for the development and progress of human society being important basis for national economic development and the improvement of people's standards of living. Using large consumption of traditional energy source such as fossil fuel, pollution of environment is worsening and the global energy crisis has become a serious issue.

Because a solar cell uses solar energy, being infinite and environmental-friendly energy source, unlike other energy sources, the solar cell has been in the spotlight due to an energy shortage problem. Development of solar cells is an alternative solution for solving such a serious energy problem. In 1991, Graetzel et al. developed a photoelectric (solar) cell using a photoelectric conversion device named as dye-sensitized solar cell.

In the past decade, organohalide perovskite absorber was used as sensitizer in the conventional dye-sensitized solar cell (DSSC). Perovskites films have attracted tremendous attention for fabrication of light harvesting devices due to their superior properties such as a direct band gap, high carrier mobility, large absorption coefficient, and ambipolar charge transport.

Usual organohalide perovskite solar cell comprises a pair of electrodes and a perovskite active layer and one or more layers of charge transporting materials disposed therebetween, in analogy to DSSC. The perovskite layer, either with or without mesoporous scaffold or mesoporous surface-increasing scaffold structure, is sandwiched between the electron and hole transport layers (n-type and p-type, respectively). Following light excitation, negative and positive charge carriers are created in the perovskite layer and injected in the respective electron and hole transport materials. Said electrons and holes are subsequently collected as photocurrent at the front and back contacts of the cell.

The key component of this class of PV cells is ETL/active layer/HTL multiple layers, which can normally be fabricated by a layer by layer assembly process. This process consists in that electron transport layers (ETL) or hole transport layer (HTL) is firstly fabricated on the substrate followed by active layer being a light-harvesting layer and the other charge transport layers. In a typical solid-state DSSC or perovskite solar cell, an electron transporter material such as titanium dioxide is in direct electrical contact with the conducting anode and coupled with a dye or organic-inorganic perovskite onto the surfaces of the semiconductor solid or nanocrystalline.

Since organic-inorganic perovskite solar cells have been of great interest, many strategies based on compositional engineering and interface modification have been employed in order to boost the performance of perovskite solar cell over 22%. Surface modification of electron transfer layer (ETL) is one way to effectively improve the efficiency of perovskite solar cell. TiO₂ is the most common material used for the fabrication of ETL in perovskite solar cell because of the TiO₂ band alignment with perovskite film. However, the TiO₂ compact layer forming the ETL presents low electron mobility, which produces insufficient charge separation at the interface with the perovskite layer. Thus, an additional layer of mesoporous TiO₂ is deposited on top of the TiO₂ compact layer to increase the electron mobility. However, such ETL structure presents further drawbacks such as a decrease of efficiency and poor reproducibility.

To improve photovoltaic parameters of perovskite photovoltaic device, surface modification of mesoporous TiO₂ scaffold has been processed to improve the charge carrier collection. Thus a lithium treatment of mesoporous TiO₂ passivate the surface defects of ETL and improves the charge collection, resulting in higher V_{oc} and efficiency. To avoid that TiO₂ film suffers from instability under UV light, TiO₂ layer has been replaced with SnO₂ film. Although a photovoltaic device comprising a SnO₂ ETL fabricated by solution process and a planar perovskite solar cell based on SnO₂ ETL by using solution technique have been reported to show an efficiency up to 21.6% (Jiang Q. et al., 2017, 29, 1703852, Advanced Materials), the fabrication of such devices having a ETL based on SnO₂ is not reproducible. The roughness of FTO glass (transparent support) in the device does not allow preparing uniform layer of SnO₂. Therefore to avoid such a drawback, either a SnO₂ based film or layer has been deposited on top of a compact TiO₂ layer, or SnO₂ nanocrystals have been mixed with mesoporous TiO₂ nanoparticles or SnO₂ nanocrystals have been deposited on top of an anodized amorphous TiO₂ layer.

The poor stability of organic materials for electron and/or hole transport layer in such photovoltaic device prevents them to be good candidates for long-term device applications. Thus, to attempt to overcome this hurdle, metal oxide film has been used for ETL and/or HTL. Film quality and thickness of a metal oxide based hole transport layer and the presence of impurities, defects and pinholes within the film seriously affect the photoelectric conversion efficiency of solar cells. Therefore to warrant high quality of inorganic metal oxide ETL and/or HTL film, the conditions of manufacturing are costly and strict.

The present invention addresses the problems of the high cost of manufacturing of organic solar cells and the difficulty of the preparation of metal oxide perovskite thin film to ensure an effective energy conversion of the perovskite solar cell.

The present invention addresses the problem to control band alignment engineering of inorganic ETLs. There is a real need to perform interface engineering of device for enhancement of stability, especially, UV stability and for having further preparation methods in order to simplify the manufacturing process, and the reduction costs.

The present invention addresses disadvantages concerning the pure organic-inorganic perovskites: sensibility to variations during the fabrication process resulting in the decrease of the quality of the thin film of perovskite.

The present invention addresses disadvantages of photovoltaic devices comprising organic-inorganic perovskites such as low open circuit voltage (V_{oc}), thermal instability, high loss of efficiency in full illumination under the long-term (aging problem), and low light sensitivity. The present invention addresses the problems depicted above.

### Summary of the Invention

Surprisingly the inventors have found that a thin layer of amorphous metal oxide, in particular a thin layer of amorphous tin oxide, in contact with the light-harvesting layer comprising a perovskite pigment allows extracting selectively the conduction band electrons produced under illumination. Such a layer improves the efficiency of a perovskite solar cell or a photovoltaic cell comprising perovskite as light-harvester by protecting said light-harvester from photocatalytic effects of the TiO₂ and by increasing the voltage Voc and therefore the device performance, light stability and UV stability. Said thin layer of amorphous metal oxide is part of a double layer structure acting as an electron specific contact and an electron transport layer. The presence of an amorphous metal oxide layer, in particular amorphous SnO₂, on a crystalline mesoporous metal oxide layer, in particular crystalline mesoporous TiO₂, enhances the charge carrier collection and decreases the charges recombination in the photovoltaic cell.

According to one aspect, the present invention provides an optoelectronic and/or photovoltaic device comprising an electron transport layer or electron transfer layer (ETL) and a light harvesting layer, wherein the light harvesting layer comprises a metal halide perovskite and is provided on the ETL; and said ETL is a multilayer structure comprising at least two layers of metal oxide, of which layer being in contact with said light harvesting layer comprises an amorphous metal oxide.

Further aspects and preferred embodiments of the invention are detailed herein below and in the appended claims. Further features and advantages of the invention will become apparent to the skilled person from the description of the preferred embodiments given below.

### Brief Description of the Drawings

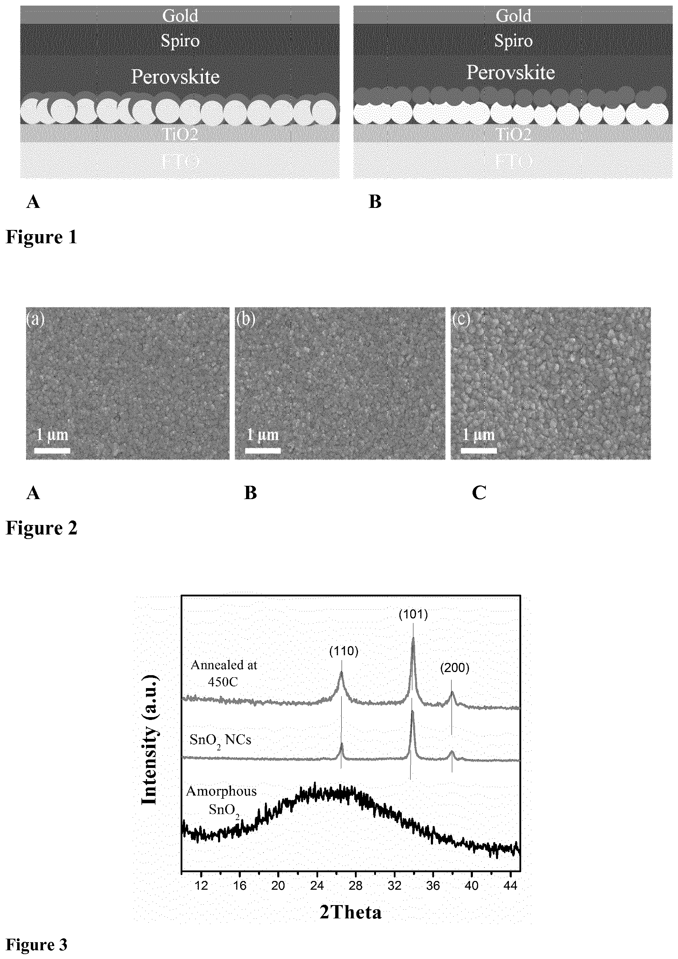

**Figure 1** illustrates schemes of two perovskite solar cell devices comprising a first bottom layer: the conducting support layer (FTO) onto which a second layer, the n-type semiconductor (TiO₂ layer) is provided, a third layer (schematically represented by a double layers of rounds), namely the ETL, based on a double layer of metal oxide being provided on the n-type semiconductor, a light harvesting layer comprising perovskite materials, a HTL comprising an organic hole transporting material (Spiro being for Spiro-OMeTAD), and a back contact (gold). **Figure 1A** shows a device, wherein the ETL comprises a first layer being a crystalline mesoporous TiO₂ (mp-TiO₂ (light rounds) covered by a second layer being an amorphous SnO₂ (a-SnO₂) layer (dark round). **Figure 1B** shows a further device, wherein the ETL comprises a first layer being a crystalline mesoporous TiO₂ covered by a second layer comprising SnO₂ nanocrystals (SnO₂ NCs).
**Figure 2** shows SEM images of top view of perovskite materials film deposited on ETLs comprising **A**: mp-TiO₂ layer, **B:** mp-TiO₂ layer covered by SnO₂ NCs layer, and **C:** mp-TiO₂ layer covered by a-SnO₂ layer.
**Figure 3** shows X-ray diffraction (XRD) patterns of annealed SnO₂ films at 180°C (bottom curve) and 450°C (top curve) and SnO₂ NCs film (middle curve). The annealing of the SnO₂ film at 180°C provides a film, the SnO₂ is in amorphous state.

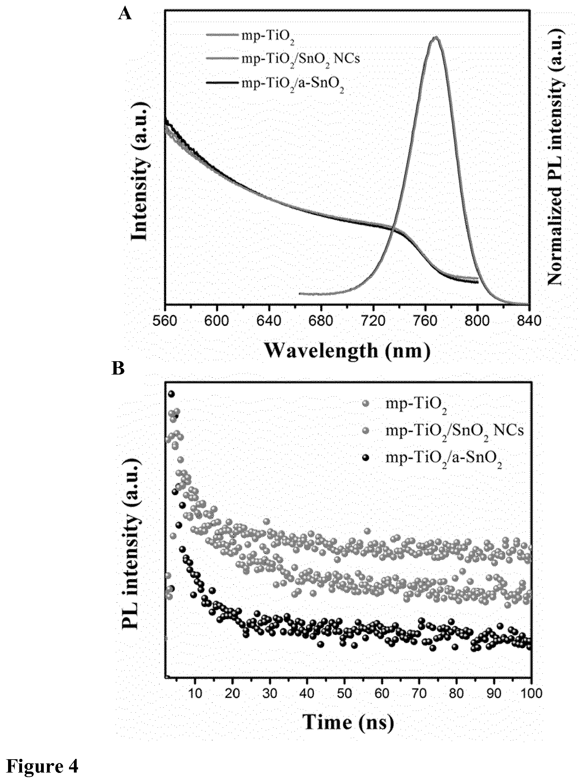

**Figure 4A** shows UV-visible and photoluminescence (PL) spectra of perovskite films provided on a ETL comprising a mp-TiO₂ layer, a mp-TiO₂ layer covered by SnO₂ NCs layer (mp-TiO₂/SnO₂ NCs), or a mp-TiO₂ layer covered by an a-SnO₂ layer (mp-TiO₂/a-SnO₂). **Figure 4B** shows time-resolved PL (TRPL) curves of perovskite films provided on a ETL comprising mp-TiO₂ (middle curve), mp-TiO₂/SnO₂ NCs (top curve), or mp-TiO₂/a-SnO₂ (bottom curve).

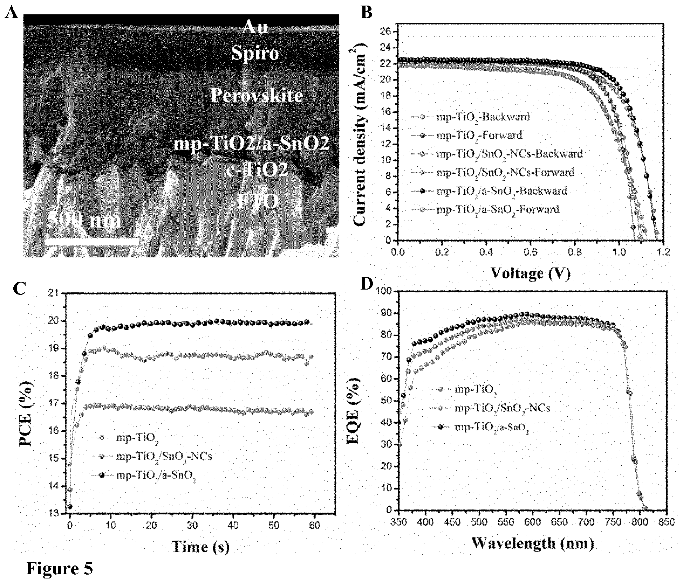

**Figure 5A** shows a cross-sectional SEM image of perovskite solar cell, wherein the perovskite material film is provided on a ETL comprising mp-TiO₂/a-SnO₂. **Figure 5B** shows graphical representation of *J-V* curves (The data are in the Examples section). **Figure 5C** shows maximum power point tracking (MPPT) curves of perovskite solar cell, wherein the perovskite material film is provided on a ETL comprising mp-TiO₂ (middle curve), mp-TiO₂/SnO₂ NCs (top curve), or mp-TiO₂/a-SnO₂ (bottom curve). **Figure 5C** shows EQE spectra of perovskite solar cells, wherein the perovskite material film is provided on a ETL comprising mp-TiO₂ (middle curve), mp-TiO₂/SnO₂ NCs (top curve), or mp-TiO₂/a-SnO₂ (bottom curve).

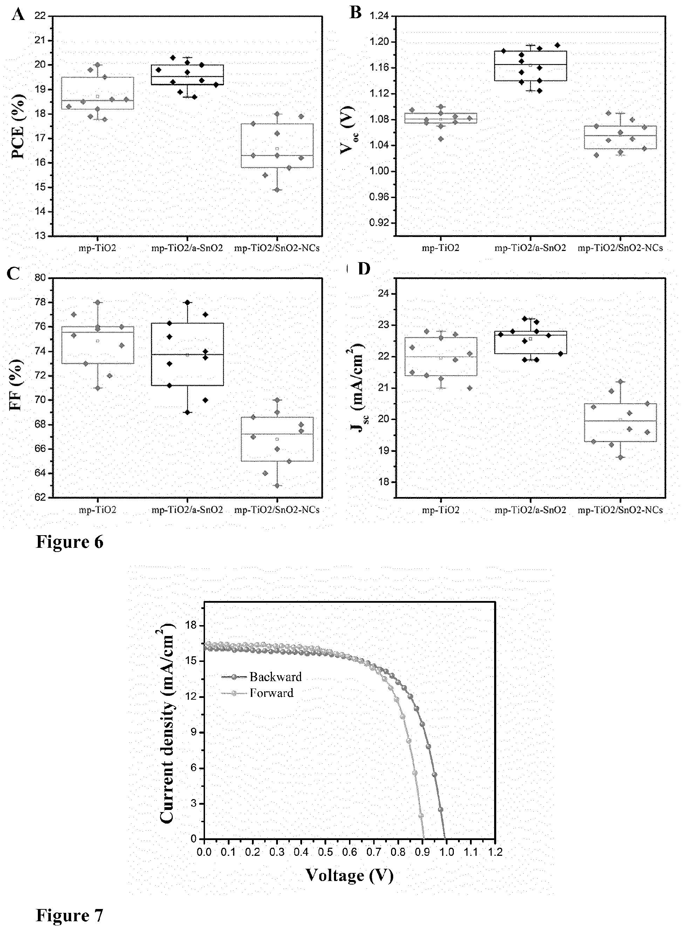

**Figure 6** shows statistical photovoltaic data concerning power conversion efficiency (PCE%) (**Figure 6A**), open circuit voltage (Voc) (**Figure 6B**), Fill Factor (FF) (**Figure 6C**) and short circuit current (Jsc) (**Figure 6D**) of perovskite solar cells, wherein the perovskite material film is provided on a ETL comprising mp-TiO₂ (left), mp-TiO₂/SnO₂ NCs (middle), or mp-TiO₂/a-SnO₂ (right).
**Figure 7** shows graphical representation of *J-V* curve of perovskite solar cells, wherein the perovskite material film is provided on a ETL comprising mp-TiO₂/SnO₂ NCs with forward (light curve) and backward (dark curve) scan directions.

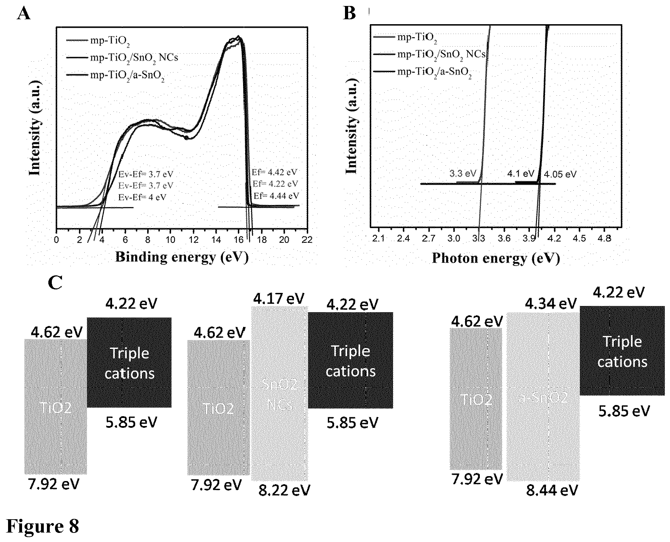

**Figure 8A** shows ultraviolet photoelectron spectroscopy (UPS) measurements and **Figure 8B** shows UV-visible spectra of SnO₂ and TiO₂ films (mp-TiO₂, mp-TiO₂/SnO₂ NCs and mp-TiO₂/a-SnO₂) on Si substrate for band levels calculation. **Figure 8C** shows schemes of band alignment of perovskite solar cells, wherein the perovskite material film is provided on a ETL comprising mp-TiO₂ (left schema), mp-TiO₂/SnO₂ NCs (middle schema), or mp-TiO₂/a-SnO₂ (right schema), the dark grey rectangle being for TiO₂, light grey rectangle being for SnO₂ and dark rectangle for the triple cation perovskite.

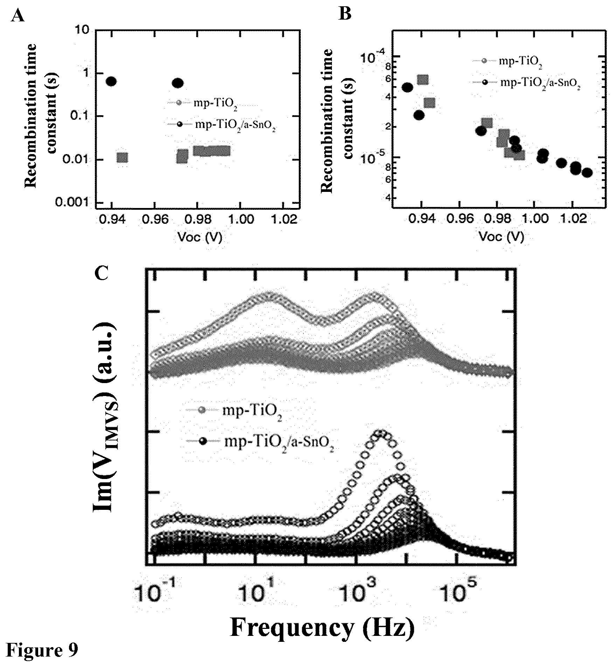

**Figures 9A and 9B** show graphics of recombination time constants of perovskite solar cells, wherein the perovskite material film is provided on a ETL comprising respectively mp-TiO₂ (square) and mp-TiO₂/a-SnO₂ (round/circle). (c) **Figures 9C** shows graphic of Imaginary part of intensity-modulated photovoltage spectroscopy (IMVS) spectra of perovskite solar cells, wherein the perovskite material film is provided on a ETL comprising respectively mp-TiO₂ (top curve) and mp-TiO₂/a-SnO₂ (bottom curve).

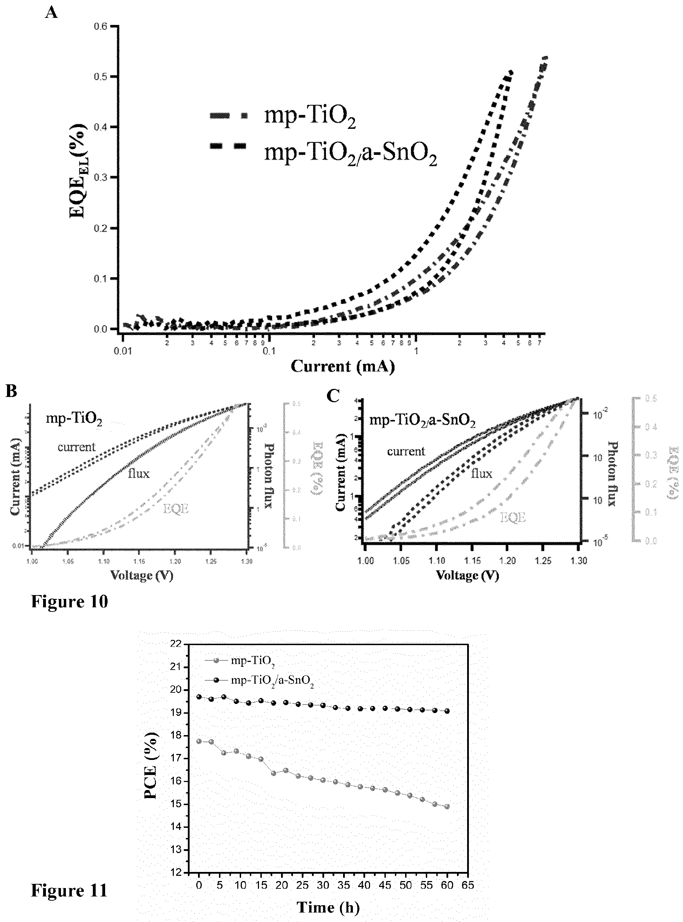

**Figure 10A** shows graphic of External Quantum Efficiency (EQE) vs Current of perovskite solar cells, wherein the perovskite material film is provided on a ETL comprising respectively mp-TiO₂ (dashed-dotted curves) and mp-TiO₂/a-SnO₂ (dashed curves). **Figure 10B** show graphic of the measurements of dark current (dashed curves), photon flux (full curves) and External Quantum Efficiency (light dashed dotted curves) of perovskite solar cells, wherein the perovskite material film is provided on a ETL comprising mp-TiO2.
**Figure 10C** shows graphic of the measurements of dark current (full dark curves), photon flux (dashed curves) and External Quantum Efficiency (dashed dotted curves) of perovskite solar cells, wherein the perovskite material film is provided on a ETL comprising mp-TiO2/a-SnO2.
**Figure 11** shows UV stability of perovskite solar cells wherein the perovskite material film is provided on a ETL comprising respectively mp-TiO₂ (bottom curve, light grey curve) and mp-TiO₂/a-SnO₂ (top curve, dark curve).

### Detailed Description of the Preferred Embodiments

The present invention concerns a optoelectronic and/or photovoltaic device comprising a structure based on ETL/active or light harvesting layer/HTL, said light harvesting layer comprising a metal halide perovskite, said structure comprising a ETL, wherein a mesoporous metal oxide layer is modified by an amorphous metal oxide layer, and said structure and/or the ETL is filled with a metal halide perovskite. Thus, the present invention provides a multilayer ETL comprising at least one amorphous metal oxide layer and at least one mesoporous metal oxide layer, said at least one amorphous metal oxide layer being in electric contact with the light harvesting layer and said at least one mesoporous metal oxide is in electric contact with at least one amorphous metal oxide layer.

For the purpose of the present specification, the expression "in electric contact with" or "in contact with" means that electrons or holes can get from one layer to the other layer with which it is in electric contact, at least in one direction. In particular, considering the electron flow in the operating device exposed to electromagnetic radiation, layers through which electrons and/or holes are flowing are considered to be in electric contact. The expression "in electric contact with" does not necessarily mean, and preferably does not mean, that electrons and/or holes can freely move in any direction between the layers. The expression "in electric contact with" or "in contact with" does not necessarily mean to be directly in electric contact with or in direct contact with, but may also mean to be "in electric contact with" through optional layer, or optional layer may be present there between.

In particular, the invention concerns an optoelectronic and/or photovoltaic device comprising an electron transport layer (ETL) and a light harvesting layer, wherein the light harvesting layer comprises a metal halide perovskite and is provided on the ETL; and said ETL is a multilayer structure comprising at least two layers of metal oxide, of which layer being in contact with said light harvesting layer comprises an amorphous metal oxide.

Said ETL and light harvesting layer may be part of the structure based on ETL/active or light harvesting layer/HTL.

According to a further embodiment, the optoelectronic and/or photovoltaic device further comprises a conducting support layer, n-type semiconductor, a hole transport layer (HTL) and a back contact, wherein the n-type semiconductor is in electric contact with the conducting support layer and the ETL is in electric contact with the n-type semiconductor; the HTL is provided on the light harvesting layer or between the light harvesting layer and the back contact; and the back contact is in electric contact with the HTL.

According to one embodiment, said HTL may be part of the structure based on ETL/active or light harvesting layer/HTL. But, the optoelectronic and/or photovoltaic device may not comprise any HTL. Preferably the optoelectronic and/or photovoltaic device comprises a HTL.

According to a further embodiment, the amorphous metal oxide is amorphous SnO₂. The mesoporous metal oxide in the ETL is in crystalline state.

In other embodiment, the ETL comprises at least one layer comprising an amorphous metal oxide and at least one layer comprising a crystalline mesoporous metal oxide. In the ETL, at least one amorphous metal oxide layer is in electric contact with the light harvesting layer and at least one mesoporous metal oxide layer is in electric contact with at least one amorphous metal oxide layer. The ETL is a multilayer structure or scaffold comprising at least two layers of metal oxide, the first layer being a mesoporous metal oxide layer and the second layer being an amorphous metal oxide layer. The ETL may comprise one or more mesoporous metal oxide layers, said mesoporous metal oxides being identical or different metal oxides. The ETL may comprise one or more amorphous metal oxide layers. When the ETL comprises more than one amorphous metal oxides layers, one amorphous metal oxide layer is in electric contact with the mesoporous metal oxide layer and one amorphous metal oxide layer is in electric contact with the light harvesting layer.

In a further embodiment, at least one layer of the ETL comprising an amorphous metal oxide is provided on the layer comprising a crystalline mesoporous metal oxide.

The metal oxides of the ETL are selected from n-type semiconductor particles being TiO₂ or ZnO particles. According to one embodiment, the crystalline mesoporous metal oxide is selected from mesoporous TiO₂ or mesoporous ZnO, most preferably from mesoporous TiO₂. The thickness of the ETL is in the range from 50 nm to 1000 nm, preferably from 50 to 600 nm. The thickness of the amorphous metal oxide layer is in the range from 10 nm to 30 nm.

In particular, the ETL comprises an amorphous metal oxide layer of amorphous SnO₂ provided on a mesoporous metal oxide layer of mesoporous TiO₂.

According to one embodiment, the ETL forms a planar structure and the metal halide perovskite infiltrates the ETL. At least, the amorphous metal oxide layer of the ETL is infiltrated by the metal halide perovskite. In an optoelectronic and/or photovoltaic device based on a ETL/light harvesting structure/HTL, the metal halide perovskite may infiltrate the whole structure.

The amorphous metal oxide layer is applied with a method selected from solution process, atomic layer deposition (ALD), sputtering technique, preferably solution process. The amorphous metal oxide layer is annealed at a temperature resulting in the formation of amorphous metal oxide, said temperature being specific to the metal oxide and lower than the temperature resulting in the crystalline state of the same metal oxide.

The conducting support layer is preferably substantially transparent. "Transparent" means transparent to at least a part, preferably a major part of the visible light. Preferably, the conducting support layer is substantially transparent to all wavelengths or types of visible light. Furthermore, the conducting support layer may be transparent to non-visible light, such as UV and IR radiation, for example. The conducting support layer provides the support layer the optoelectronic and/or photovoltaic device. Preferably, the optoelectronic and/or photovoltaic device is built on said support layer. The support of the device may be also provided on the side of the back contact or counter electrode. In this case, the conductive support layer does not necessarily provide the support of the device, but may simply be or comprise a current collector, for example a metal foil.

The conducting support layer functions and/or comprises a current collector, collecting the current obtained from the device. The conducting support layer may comprise a material selected from indium doped tin oxide (ITO), fluorine doped tin oxide (FTO), ZnO-Ga₂O₃, ZnO-Al₂O₃, tin-oxide, antimony doped tin oxide (ATO), SrGeO₃ and zinc oxide, preferably coated on a transparent substrate, such as plastic or glass. In this case, the plastic or glass provides the support structure of the layer and the cited conducting material provides the conductivity. Such support layers are generally known as conductive glass and conductive plastic, respectively, which are thus preferred conducting support layers in accordance with the invention. The conducting support layer comprises a conducting transparent layer, which may be selected from conducting glass and from conducting plastic. In a further embodiment, the n-type semiconductor comprises a metal oxide layer. Preferably the n-type semiconductor comprises a compact metal oxide layer.

According one embodiment The n-type semiconductor further comprises a mesoporous/ nanoporous/nanostructured metal oxide being a surface-increasing scaffold structure provided onto the compact metal oxide layer.

In another embodiment, the ETL is provided on the compact metal oxide layer of the n-type semiconductor or on the surface-increasing scaffold structure of the n-type semiconductor. In a further embodiment, such a scaffold structure may be absent of the n-type semiconductor, and the ETL is provided on the compact metal oxide layer of the n-type semiconductor, the mesoporous metal oxide layer of the ETL being used as a surface-increasing scaffold structure.

The n-type semiconductor comprises metal oxide particles selected from Si, TiO₂, SnO₂, ZnO, Zn₂SnO₄, Nb₂O₅, WO₃, BaTiO₃ or SrTiO₃ or any combination thereof. The metal oxide particles of the mesoporous layer and the metal oxide particles of the scaffold structure may be made of the same or different metal oxide described above.

By "hole transport material", "hole transporting material", "organic hole transport material" and "inorganic hole transport material", and the like, is meant any material or composition wherein charges are transported by electron or hole movement (electronic motion) across said material or composition. The "hole transport material" is thus an electrically conductive material. Such hole transport materials, etc., are different from electrolytes. In this latter, charges are transported by diffusion of molecules.

Hole transport material may be preferably selected from organic and inorganic hole transport materials or p-type semiconductor.

According to an embodiment, the hole transport material is selected from triphenylamine, carbazole, N,N,(diphenyl)-N',N'di-(alkylphenyl)-4,4'-biphenyldiamine, (pTPDs), diphenylhydrazone, poly [N,N'-bis(4-butylphenyl)-N,N'-bis(phenyl)benzidine] (polyTPD), polyTPD substituted by electron donor groups and/or acceptor groups, poly(9,9-dioctylfluorene-alt-N-(4-butylphenyl)-diphenylamine (TFB), 2,2',7,7'-tetrakis-N,N-di-p-methoxyphenylamine-9,9'-spirobifluorene) (spiro-OMeTAD), N,N,N',N'-tetraphenylbenzidine (TPD), PTAA (Poly[bis(4-phenyl)(2,4,6-trimethylphenyl)amine]).

In a further embodiment, the hole transporting layer comprises one or more inorganic hole transporting materials or inorganic p-type semiconductors selected from NiO, CuO, CuSCN, CuI, CuGaO₂, CuCrO₂, CuAlO₂, CsSnI₃, MoO₃ or WoO₃ or any combination thereof. Preferably, the semiconductor particles are selected from NiO, CuO, CuSCN, CuI, CuGaO2, CuCrO₂ or CuAlO₂ or any combination thereof, most preferably from NiO, CuO, CuSCN, CuI. The thickness of the p-type semiconductor layer is in the range from 40 nm to 1000 nm, from 40 to 200nm, from 40 to 70 nm, from 40 to 60 nm. Preferably the hole transporting layer comprises a film free of pinholes and having a thickness from 40 to 70 nm. The hole transporting layer is under the form of a thin film free of pinholes and uniform, i.e. comprising one type of conformal structure or mono typism (only one type of layer stacking order) of the hole transporting material. Such a type of film is provided by dynamic deposition method of the hole transporting material in solution on the perovskite or sensitizer or light-absorber layer or, if present the spacer layer, said method comprising a drop-casting step with spinning of the hole transporting material in solution, namely dissolved in a solvent selected from diethyl sulfide, propyl sulphide, or a mixture of diethyl and propyl sulphide and drop-casted in a short time period (2-3 seconds) with a spinning at 5000 rpm. Said hole transporting layer is preferable free of p-dopant or other organic hole transporting material.

The deposition of the inorganic p-type semiconductor is not limited to the dynamic deposition. It may also include different methods, such as doctor blading, electrodeposition, spin coating, and spray coating. The deposition of the inorganic hole transporting material with this dynamic method, namely drop-casting with spinning allows to obtain very thin film without pinholes, which provides stability to a device to resist to thermal stress and aging and lead to retain about 85% of the initial PCE of the device during said thermal stress and aging treatment.

According to one embodiment, the ETL comprising an amorphous SnO₂ layer or film is used in optoelectronic and/or photovoltaic devices, wherein the devices are free of organic hole transport material.

The back contact generally comprises a catalytically active material, suitable to provide electrons and/or fill holes towards the inside of the device. The back contact may comprise one or more materials selected from Pt, Au, Ni, Cu, Ag, In, Ru, Pd, Rh, Ir, Os, porous carbon (C), conductive polymer and a combination of two or more of the aforementioned. Conductive polymers may be selected from polymers comprising polyaniline, polypyrrole, polythiophene, polybenzene, polyethylenedioxythiophene, polypropylenedioxy-thiophene, polyacetylene, and combinations of two or more of the aforementioned, for example. In to an embodiment, the back contact comprises a material selected from a metal selected from Pt, Au, Ni, Cu, Ag, In, Ru, Pd, Rh, Ir, or Os, from porous carbon or from conductive polymer as defined above or a combination thereof. Preferably the back contact is selected from gold (Au), silver (Ag), aluminum (Al), copper (Cu), platinum (Pt), nickel (Ni). Furthermore, the back contact is more preferably gold (Au) with a thickness of range between 50 nm and 200 nm. Additionally, said electrode may be porous Carbon (C).

The term "perovskite", for the purpose of this specification, refers to the "perovskite structure" and not specifically to the perovskite material, CaTiO₃. For the purpose of this specification, "perovskite" encompasses and preferably relates to any material that has the same type of crystal structure as calcium titanium oxide and of materials in which the bivalent cation is replaced by two separate monovalent cations. The perovskite structure has the general stoichiometry AMX₃, where "A" and "M" are cations and "X" is an anion. The "A" and "M" cations can have a variety of charges and in the original Perovskite mineral (CaTiO₃), the A cation is divalent and the M cation is tetravalent. For the purpose of this invention, the perovskite formulae include structures having three or four anions, which may be the same or different, and/or one or two organic cations, and/or metal atoms carrying two or three positive charges, in accordance with the formulae presented elsewhere in this specification.

The sensitizer or light-absorber layer may comprise one or more layers of an organic-inorganic perovskite or a metal halide perovskite. In said device, the last upper layer of organic-inorganic perovskite or metal halide perovskite is coated by the hole transport material or, if present by the spacer layer. The organic-inorganic perovskite or metal halide perovskite may be provided on the mesoscopic part of the n-type semiconductor on the metal oxide layer.

According to another embodiment, the perovskite or metal halide perovskite is selected from a perovskite structure according to any one of formulae (I), (Ia), (Ib), (Ic), (Id), (Ie), (If) and/or (Ig) below:

AA'MX₄ (I)

AMX₃ (Ia)

AA'N_{2/3}X₄ (Ib)

AN_{2/3}X₃ (Ic)

BN_{2/3}X₄ (Id)

BMX₄ (Ie)

(A₁)ₘAA'MX₃ (If)

(A₁)ₘAMX₃ (Ig)

wherein,
- A and A' are organic, monovalent cations being independently selected from primary, secondary, tertiary or quaternary organic ammonium compounds, including N-containing hetero rings and ring systems, A and A' having independently from 1 to 60 carbons and 1 to 20 heteroatoms;
- A₁ is an inorganic cation selected from Cs⁺, Rb⁺, K⁺ and m is an integer from 1 to 3, each A₁ if m >1 being different;
- B is an organic, bivalent cation selected from primary, secondary, tertiary or quaternary organic ammonium compounds having from 1 to 60 carbons and 2-20 heteroatoms and having two positively charged nitrogen atoms;
- M is selected from Cu²⁺ Ni²⁺, Co²⁺, Fe²⁺, Mn²⁺, Cr²⁺, Pd²⁺, Cd²⁺, Ge²⁺, Sn²⁺, Pb²⁺, Eu²⁺, Yb²⁺, [SnᵢPb₍₁₋ᵢ₎]⁺, [SnⱼGe₍₁₋ⱼ₎]⁺, and [PbₖGe₍₁₋ₖ₎]⁺,i, j and k being a number between 0.0 and 1.0;
- N is selected from the group of Bi³⁺ and Sb³⁺; and,
- X are independently selected from Cl⁻, Br⁻, I⁻, NCS⁻, CN⁻, NCO⁻, from [I₍₃₋ₘ₎Clₘ]⁻, [I₍₃₋ₙ₎Brₙ]⁻, [Br₍₃₋ᵤ₎Clᵤ]⁻, m, n u being a number between 0.0 and 3.0, and from a combination of two anions selected from Cl⁻, Br⁻, I⁻.

In particular, the three or four X may be identical or different. For example, in AMX₃ (formula Ia) may be expressed as formula (Ia') below:

AMXiXiiXiii (Ia')

wherein Xi, Xii, Xiii are independently selected from Cl⁻, Br⁻, I⁻, NCS⁻, CN⁻, NCO⁻, from [I₍₃₋ₘ₎Clₘ]⁻, [I₍₃₋ₙ₎Brₙ]⁻, [Br₍₃₋ᵤ₎Clᵤ]⁻, m, n u being a number between 0.0 and 3.0, and from a combination of two anion selected from Cl⁻, Br⁻, I⁻, preferably from halide (Cl⁻, Br⁻, I⁻) and A and M are as defined elsewhere in this specification. Xi, Xii, Xiii may thus be the same or different in this case.

Preferably, if Xi, Xii, Xiii in formulae (Ia) and (Ic) or Xi, Xii, Xiii, Xiv in formulae (I), (Ib), (Id) or (Ie) comprise different anions X, there are not more than two different anions. For example, Xi and Xii being the same with Xiii being an anion that is different from Xi and Xii.

According to perovskite-structure of formula (If) or (Ig), A and A' are independently selected from methylammonium cation, formamidinium cations, iodo-carbamimidoyl cation or a combination of said cations.

According to a preferred embodiment, said perovskite or metal halide perovskite layer comprises a perovskite-structure according to any one of the formulae (Ih) to (Im):

APbX₃ (Ih)

ASnX₃ (Ii)

ABiX₄ (Ij)

AA'PbX₄ (Ik)

AA'SnX₄ (IIj)

BPbX₄ (Il)

BSnX₄ (Im) wherein A, A', B and X are as defined above in this specification. Preferably, X is preferably selected from Cl⁻, Br⁻ and I⁻, most preferably X is I⁻ or a mixture of Br⁻ and I⁻.

The sensitizer or light-absorber layer comprising organic-inorganic perovskite or metal halide perovskite may comprise a perovskite-structure according to any of the formulae (If) to (Im), more preferably (If) (Ih) and/or (Ii).

According to an embodiment, A and A' are monovalent cations selected independently from any one of the compounds of formulae (20) to (28) below: 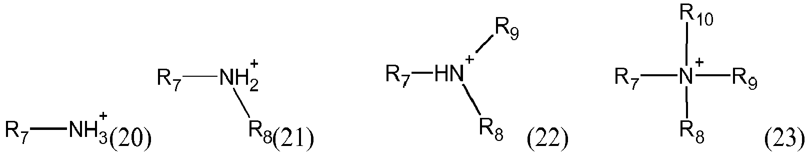 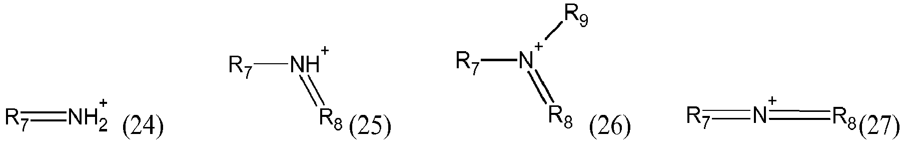 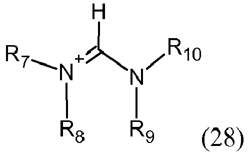 wherein,
R₇, R₈, R₉ and R₁₀ is independently selected from C1-C15 organic substituents comprising from 0 to 15 heteroatoms.

According to an embodiment of said C1-C15 organic substituent any one, several or all hydrogens in said substituent may be replaced by halogen and said organic substituent may comprise up to fifteen (15) N, S or O heteroatoms, and wherein, in any one of the compounds (20) to (28), the two or more of substituents present (R₇, R₈, R₉ and R₁₀, as applicable) may be covalently connected to each other to form a substituted or unsubstituted ring or ring system. Preferably, in a chain of atoms of said C1-C15 organic substituent, any heteroatom is connected to at least one carbon atom. Preferably, neighboring heteroatoms are absent and/or heteroatom-heteroatom bonds are absent in said C1-C15 organic substituent comprising from 0 to 15 heteroatoms. The heteroatoms may be selected from N, S, and/or O.

According to an embodiment, R₇, R₈, R₉ and R₁₀ are independently selected from C1 to C15 aliphatic and C4 to C15 aromatic or hetero aromatic substituents, wherein any one, several or all hydrogens in said substituent may be replaced by halogen and wherein, in any one of the compounds (20) to (28), the two or more of the substituents present may be covalently connected to each other to form a substituted or unsubstituted ring or ring system.

According to a preferred embodiment, the organic-inorganic perovskite is selected from a compound of formula (I), (Ia), (If) or (Ig).

According to an embodiment, B is a bivalent cation selected from any one of the compounds of formulae (49) and (50) below: 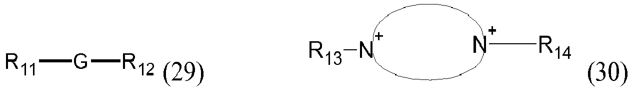 wherein,
in the compound of formula (29), G is an organic linker structure having 1 to 10 carbons and 0 to 5 heteroatoms selected from N, S, and/or O, wherein one or more hydrogen atoms in said G may be replaced by halogen;
wherein R₁₁ and R₁₂ are independently selected from a compounds of any one of formulae (20) to (28); and wherein, in the compound of formula (30), the circle containing said two positively charged nitrogen atoms represents a substituted or unsubstituted aromatic ring or ring system comprising 4 to 15 carbon atoms and 2 to 7 heteroatoms or 4 to 10 carbon atoms and 2 to 5 heteroatoms, wherein said nitrogen atoms are ring heteroatoms of said ring or ring system, and wherein the remaining of said heteroatoms may be selected independently from N, O and S and wherein R₁₃ and R₁₄ are independently selected from H and from a compounds of any one of formulae (20) to (28). Halogen atom substituting hydrogen atom totally or partially may also be present in addition to and/or independently of said 2 to 7 heteroatoms.

Preferably, if the number of carbons is in G is impair, the number of heteroatoms is smaller than the number of carbons. Preferably, in the ring structure of formula (30), the number of ring heteroatoms is smaller than the number of carbon atoms. According to an embodiment, G is an aliphatic, aromatic or hetero aromatic linker structure having from 1 to 10 carbons.

According to an embodiment, R₇, R₈, R₉ and R₁₀ are independently selected from C1 to C10 alkyl, C2 to C10 alkenyl, C2 to C10 alkynyl, C4 to C10 heteroaryl and C6 to C10 aryl, wherein said alkyl, alkenyl, and alkynyl, if they comprise 3 or more carbons, may be linear, branched or cyclic, wherein said heteroaryl and aryl may be substituted or unsubstituted, and wherein several or all hydrogens in R₇, R₈, R₉ and R₁₀ may be replaced by halogen.

According to an embodiment, R₇, R₈, R₉ and R₁₀ are independently selected from C1 to C8 alkyl, C2 to C8 alkenyl, C2 to C8 alkynyl, C4 to C8 heteroaryl and C6 to C8 aryl, wherein said alkyl, alkenyl, and alkynyl, if they comprise 3 or more carbons, may be linear, branched or cyclic, wherein said heteroaryl and aryl may be substituted or unsubstituted, and wherein several or all hydrogens in R₇, R₈, R₉ and R₁₀ may be replaced by halogen.

According to an embodiment, R₇, R₈, R₉ and R₁₀ are independently selected from C1 to C6 alkyl, C2 to C6 alkenyl, C2 to C6 alkynyl, C4 to C6 heteroaryl and C6 aryl, wherein said alkyl, alkenyl, and alkynyl, if they comprise 3 or more carbons, may be linear, branched or cyclic, wherein said heteroaryl and aryl may be substituted or unsubstituted, and wherein several or all hydrogens in R₇, R₈, R₉ and R₁₀ may be replaced by halogen.

According to an embodiment, R₇, R₈, R₉ and R₁₀ are independently selected from C1 to C4 alkyl, C2 to C4 alkenyl and C2 to C4 alkynyl, wherein said alkyl, alkenyl and alkynyl, if they comprise 3 or more carbons, may be linear, branched or cyclic, and wherein several or all hydrogens in R₇, R₈, R₉ and R₁₀ may be replaced by halogen.

According to an embodiment, R₇, R₈, R₉ and R₁₀ are independently selected from C1 to C3, preferably C1 to C2 alkyl, C2 to C3, preferably C2 alkenyl and C2 to C3, preferably C2 alkynyl, wherein said alkyl, alkenyl and alkynyl, if they comprise 3 or more carbons, may be linear, branched or cyclic, and wherein several or all hydrogens in R₇, R₈, R₉ and R₁₀ may be replaced by halogen.

According to an embodiment, R₇, R₈, R₉ and R₁₀ is independently selected from C1 to C4, more preferably C1 to C3 and even more preferably C1 to C2 alkyl. Most preferably R₇, R₈, R₉ and R₁₀ are methyl. Again, said alkyl may be completely or partially halogenated.

According to an embodiment, A, A' and B are monovalent (A, A') and bivalent (B) cations, respectively, selected from substituted and unsubstituted C5 to C6 rings comprising one, two or more nitrogen heteroatoms, wherein one (for A and A') or two (for B) of said nitrogen atoms is/are positively charged. Substituents of such rings may be selected from halogen and from C1 to C4 alkyls, C2 to C4 alkenyls and C2 to C4 alkynyls as defined above, preferably from C1 to C3 alkyls, C3 alkenyls and C3 alkynyls as defined above. Said ring may comprise further heteroatoms, which may be selected from O, N and S. Bivalent organic cations B comprising two positively charged ring N-atoms are exemplified, for example, by the compound of formula (30) above. Such rings may be aromatic or aliphatic.

A, A' and B may also comprise a ring system comprising two or more rings, at least one of which being from substituted and unsubstituted C5 to C6 ring as defined as above. The elliptically drawn circle in the compound of formulae (30) may also represent a ring system comprising, for example, two or more rings, but preferably two rings. Also, if A and/or A' comprises two rings, further ring heteroatoms may be present, which are preferably not charged, for example.

According to an embodiment, however, the organic cations A, A' and B comprise one (for A, A'), two (for B) or more nitrogen atom(s) but are free of any O or S or any other heteroatom, with the exception of halogens, which may substitute one or more hydrogen atoms in cation A and/or B.

A and A' preferably comprise one positively charged nitrogen atom. B preferably comprises two positively charged nitrogen atoms.

A, A' and B may be selected from the exemplary rings or ring systems of formulae (31) and (32) (for A, A') and from (33) to (35) (for B) below: 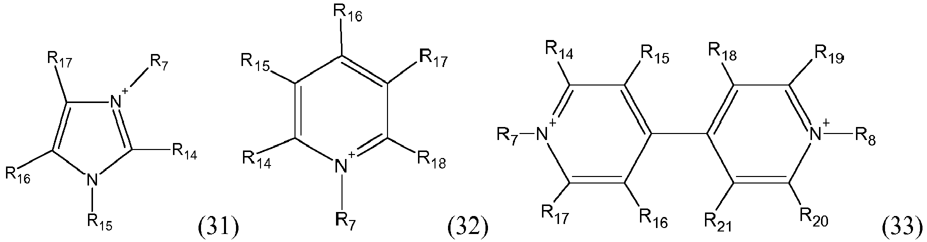 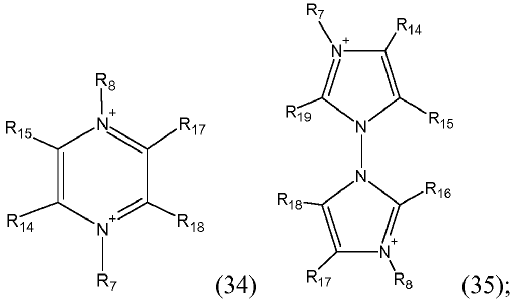 wherein
R₇ and R₈ are selected from substituents as defined above, and R₁₄, R₁₅, R₁₆, R₁₇, R₁₈, R₁₉, R₂₀ and R₂₁ are independently selected from H, halogen and substituents as defined above for R₇, R₈, R₉ and R₁₀. Preferably, R₁₄, R₁₅, R₁₆, R₁₇, R₁₈, R₁₉, R₂₀ and R₂₁ are selected from H and halogen, most preferably H.

In the organic cations A, A' and B, hydrogen atoms may be substituted by halogens, such as F, Cl, I, and Br, preferably F or Cl. Such a substitution is expected to reduce the hygroscopic properties of the perovskite layer or layers and may thus provide a useful option for the purpose of the present specification.

According to a preferred embodiment, A and A' are independently selected from organic cations of formula (20) and/or formula (28).

According to a preferred embodiment, the metal M is selected from Sn²⁺ and Pb²⁺, preferably Pb²⁺. According to a preferred embodiment, N is Sb³⁺.

According to a preferred embodiment, the three or four X are independently selected from Cl⁻, Br⁻, and I⁻.

The light harvesting compound used in these devices is not restricted to perovskite light absorbers but also comprising of a two dimensional (2D) or three dimensional (3D) or combination of both.

According to one embodiment, the optoelectronic and/or photovoltaic device is selected from an organic photovoltaic device, a photovoltaic solid state device, a p-n heterojunction, a metal organohalide perovskite photovoltaic device, a metal organohalide perovskite solar cell, a solid state solar cell, a phototransistor and LED (light-emitting diode). Said optoelectronic and/or photovoltaic or photovoltaic device may be selected from a photovoltaic device, a solid state solar cell. Said photovoltaic device is selected from an organic solar cell, a solid state solar cell, from a p-n heterojunction, a phototransistor or LED (light-emitting diode), preferably from a solar cell or a solid state solar cell. The optoelectronic and/or photovoltaic device may be operated in forward bias to serve as a light emitting diode (LED).

The present invention is described more concretely with reference to the following examples, which, however, are not intended to restrict the scope of the invention.

### Examples

### Preparation of a mesoscopic inorganic metal oxide framework

FTO glasses (NSG-10) were chemically etched using zinc powder and HCl solution (2 M), followed by four steps ultrasonic cleaning using Triton X100 (1 vol% in deionized water), DI water, acetone, and ethanol, respectively. All substrates were further cleaned by ozone plasma for 15 min, before deposition of each ETL. To prepare TiO₂ compact layer, a precursor solution of titanium diisopropoxide (Sigma-Aldrich) in ethanol was deposited on substrates at 450 °C using spray pyrolysis process, followed by 30 min annealing at 450°C. Afterward, a 150 nm-thick mesoporous TiO₂ was spin coated on compact TiO₂ (4000 rpm for 15 s with a ramp rate of 2000 rpm/s) from a diluted TiO₂ paste (Dyesol 30 NR-D) in ethanol, followed by annealing the substrates at 450°C for 30 min. This mesoscopic structure could be other types of metal oxides such as ZnO.

### Surface modification of mesoscopic framework

### Deposition of amorphous SnO₂ film

In order to modify surface of mp-TiO₂, SnO₂ precursor solution (0.1 M SnCl₂.2H₂O in ethanol) was spin-coated on top of mp-TiO₂ with 20 s delay time for better penetration and 6000 rpm for 40 s. Then, the film was annealed at 180 °C for 1 hour. For planar structure of perovskite device, we have deposited SnO₂ layer only on planar TiO₂ film without using mesoscopic TiO₂. The condition was the same as mesoscopic structure.

### Deposition of crystalline SnO₂ film

In order to make crystalline SnO₂ (c-SnO₂), the deposited SnO₂ film was annealed at 450 °C for 1 hour. In addition to SnO₂ thin film, SnO₂ NCs are purchased from Sigma Aldrich and deposited on top of mp-TiO₂ (5000 rpm for 20 s with 2000 ramp-rate), followed by annealing at 200 °C for 1 hour.

### Preparation of perovskite solution

For deposition of perovskite film, (FAPbI₃)_{0.87}(MAPbBr₃)_{0.13} precursor solution was prepared by mixing FAI (1.05 M, Dyesol), PbI₂ (1.10 M, TCI), MABr (0.185 M, Dyesol) and PbBr₂ (0.185 M, TCI) in a mixed solvent of DMF:DMSO = 4:1 (volume ratio). Then, CsI solution (1.5 M in DMSO) with 5 vol% was added into the perovskite solution in order to make a triple cation.

### Deposition of perovskite film

The solution was spin-coated at 1000 rpm for 10 s and, continuously at 4000 rpm for 30 s. During the second step, 200 µL of chlorobenzene was dropped on top film 10 second before end of spinning. Afterward, the film was annealed at 120 °C for 10 min followed by annealing at 100 °C for 40 min.

### Hole transfer layer deposition and back contact

After annealing and cooling the samples, spiro-OMeTAD solution in chlorobenzene (70 mM) containing bis(trifluoromethylsulfonyl)imide lithium salt (Li-TFSI, Sigma-Aldrich), (4-tert-butylpyridine-Sigma-Aldrich) with molar ratios of 0.5 and 3.3, respectively, was prepared and spin-coated at 4000 rpm for 20 s (with ramp rate of 2000). Finally, 80-nm thick gold was thermally evaporated as a back contact to complete the device structure with an active area of 0.16 cm².

### Film characterization

The morphology of perovskite film, and device structure was studied using Field-emission scanning electron microscopy (FESEM, Hitachi S4160, Japan) equipped. Quality and crystal structure of perovskite films were characterized by using X-ray diffraction (Bruker D8 X-ray Diffractometer, USA) utilizing a Cu *Kα* radiation. Transmission electron microscopy (JEOL (2010F) under an accelerating voltage of 200 volts) was employed to take images from SnO₂ nanocrystals. The fermi levels and valence bands of ETLS were measured by ultraviolet photoelectron spectroscopy (UPS, AXIS NOVA, Kratos Analytical Ltd, UK) using He I (21.2 eV) as the photon source.

### Optical Characterization

For optical absorption measurement, a Varian Carry 500 spectrometer (Varian, USA) was used. To record Steady-state photoluminescence spectra, an Edinburgh Instruments FLS920P fluorescence spectrometer. For lifetime measurement (TRPL), a picosecond pulsed diode laser (EPL-405, excitation wavelength 405 nm, pulse width 49 ps) was employed. In order to analysis of TRPL results, PL decay curves were fitted to the following exponential function I(t) = I₀exp(-(tᵢ/τᵢ)^{βi}), where τᵢ is the decay time and βᵢ is a stretch parameter.

### Device characterization

The solar cells were measured under AM1.5G sun simulator (a 450 W Xenon lamp (Oriel), with intensity of 100 mWcm⁻², equipped with a Schott K113 Tempax sunlight filter (PraezisionsGlas&Optik GmbH) to simulate the emission spectra of AM1.5G standard in the region of 350-750 nm. Calibration of the lamp was performed using standard Silicon solar cell (KG5-filtered Si reference cell). To measure the current density-voltage (*J*-*V*) curves, a 2400 series source meter (Keithley, USA) instrument was employed. The voltage range for *J-V* sweeps was between 0 and 1.2 V, with a step size of 0.005 V and a delay time of 200ms at each point. External quantum efficiency (EQE) spectra were measured by the 300W Xenon lamp (ILC Technology, U.S.A.) through a Gemini-180 double monochromator (JobinYvon Ltd., U.K.). The monochromatic light was chopped at 3 Hz before measurement. The monochromator was incremented through the visible spectrum to generate the IPCE dependence on wavelength. The UV stability of devices was measured inside a dry air box using a UV lamp (Spectronics ENF-240C) with power of 50 mW/cm².

Figure 1A and B shows the schematics of perovskite solar cells based on a-SnO₂/mp-TiO₂ and SnO₂ NCs/mp-TiO₂ ETLs. As it can be seen, the surface of mp-TiO₂ covered by a thin layer of a-SnO₂, c-SnO₂, and SnO₂ NCs. The device structure is consisted of FTO glass coated by a compact TiO₂ layer, a 150 nm-thick mp-TiO₂, a thin layer of SnO₂, a perovskite film with 300 nm-thick, a 150 nm-thick spiro-OMeTAD as a hole transfer layer (HTL), and gold contact with thickness of 80 nm. Top-view SEM images of perovskite films on different ETLs are shown in Figure 2. As seen, the grain size of perovskite film on a-SnO₂ is slightly larger than perovskite films on top of mp-TiO₂ and SnO₂ NCs. This indicates that the number of nucleation cites in amorphous SnO₂ (continuous film) is less than other substrates, resulting in larger grain size for perovskite film.

X-ray diffraction (XRD) patterns of SnO₂ films deposited from solution and nanocrystals colloid are shown in Figure 3. It is clear that the SnO₂ film annealed at 180 °C indicates amorphous nature as evidenced by XRD pattern, while the annealed sample at 450 °C and SnO₂ NCs film are fully crystalline.³² All the peaks for SnO₂ film annealed at 450 °C correspond to tetragonal SnO₂ (JCPDS Card No: 41-1445). Notable the XRD pattern of annealed sample at 450 °C are almost matched with those observed for SnO₂ NCs layer deposited from commercial SnO₂ colloids with 3-5 nm size, followed by annealing at 150 °C.³³

Figure 4 demonstrates optical properties of perovskite film on different ETLs. As shown in Figure 4a, the triple cations perovskite film shows absorption peak at 760 nm, resulting in a band gap of 1.63 eV. In order to understand the charge separation efficiency of devices, time-resolved PL (TRPL) of films is measured. As seen in Figure 4b, PL quenching effect is significantly influenced by ETLs, where the highest PL quenching is observed for mp-TiO₂/a-SnO₂ substrate, which is the most efficient charge separation among the ETLs. The calculated values from bi-exponential equation indicate that the lifetime for perovskite film on mp-TiO₂, mp-TiO₂/SnO₂ NCs, and mp-TiO₂/a-SnO₂ are 2.43 ns, 3.21 ns, and 1.93 ns, respectively. This suggests that the presence of SnO₂ layer on mp-TiO₂ only in the amorphous phase can improve the charge separation in the perovskite film, while the crystalline phase of SnO₂ has a negative effect on charge extraction efficiency of perovskite device.

**Table 1. Figure of merits for devices based on mp-TiO₂, mp-TiO₂/SnO₂ NCs, and mp-TiO₂/a-SnO₂ with different scan directions**

| Sample | *V_{oc}*(V) | *J_{sc}*(mA/cm²) | *FF* (%) | PCE (%) | Hysteresis index (%) |
|---|---|---|---|---|---|
| Mp-TiO₂-forward | 1.078 | 22.12 | 78.1 | 18.62 | 2.7 |
| Mp-TiO₂-backward | 1.098 | 22.21 | 78.5 | 19.14 | |
| Mp-TiO₂/SnO₂ NCs-forward | 1.114 | 21.76 | 67.8 | 16.43 | 3 |
| Mp-TiO₂- SnO₂ NCs-backward | 1.135 | 21.83 | 68.4 | 16.95 | |
| Mp-TiO₂/a-SnO₂-forward | 1.171 | 22.47 | 76.8 | 20.21 | 1.1 |
| Mp-TiO₂/a-SnO₂-backward | 1.168 | 22.51 | 77.6 | 20.4 | |

In order to study the photovoltaic properties, perovskite solar cells based on these ETLs were fabricated as explained in the experimental section. Figure 5a demonstrates the cross-sectional SEM image of perovskite device based on mp-TiO₂/a-SnO₂. Current density-voltage (*J-V*) curves of devices on different ETLs under simulated (AM1.5G) solar irradiation (forward and backward scan directions) are shown in Figure 5b. The reference cell based on mp-TiO₂ gave a *J_{sc}* of 22.21 mA/cm², *V_{oc}* of 1.098 V, fill factor (*FF*) of 78.5%, and PCE of 19.14%. In contrast, the device on SnO₂ layers exhibit improvement in *V_{oc}.*

The figure of merits for champion devices is listed in Table1. As observed in Figure 5b, the perovskite solar cell based on mp-TiO₂/a-SnO₂ presents the highest PCE up to 20.4% with *V_{oc}* of 1.168 V, *J_{sc}* of 22.51, and *FF* of 77.6%, which is 6% and 17% better than devices on mp-TiO₂ and mp-TiO₂/SnO₂ NCs, respectively. Beside the hysterias indexes of devices on these ETLs were calculated from the following formula (h=(PCE_{backward}- PCE _{forward})/ PCE_{backward})*100). The results indicate a negligible hysteresis value for all devices, especially for device on mp-TiO₂/a-SnO₂, due to improvement of interfacial properties. Figure 6 demonstrates the statistical data for devices (10 cells) on different ETLs. The average values of photovoltaic parameters depict that the presence of an amorphous SnO₂ film on mp-TiO₂ is increased all photovoltaic parameters except *FF*. As seen, V_{oc} of device on mp-TiO₂/a-SnO₂ drastically is increased. However, the presence of SnO₂ NCs on mp-TiO₂ shows a negative effect on all photovoltaic parameters as compared with reference cell. This suggests that the annealing temperature and crystal structure of SnO₂ film play an important role in device performance. Figure 7 shows the *J-V* curve of device on SnO₂ film coated-on mp-TiO₂ annealed at 450 °C. The results prove that a crystalline SnO₂ film (as shown in Figure 3) cannot be matched with perovskite film, resulting in a poor device performance. Despite similar XRD feature to SnO₂ NCs, photovoltaic performance of the 450 °C-annealed SnO₂ is worse than that of the SnO₂ NCs, which is mainly due to the incomplete coverage of surface after annealing at high temperature. Besides, the stabilized maximum power point of devices on mp-TiO₂, mp-TiO₂/SnO₂ NCs, and mp-TiO₂/a-SnO₂ are 18.89, 16.75, and 20.27 mW/cm², respectively, as shown in Figure 5C, which indicate that the efficiency of devices is stable over time. Figure 5d shows the external quantum efficiency (EQE) of these devices. As can be seen, the EQE of perovskite device on mp-TiO₂/a-SnO₂ is slightly higher than others cells, which is in good agreement with *J-V* results. To further study the effect of SnO₂ nature on device performance, the band alignment of devices with different ETLs were extracted from ultraviolet photoelectron spectroscopy (UPS) and UV-visible results. As shown in Figure 8a, the valence band and fermi level of different ETLs are calculated from UPS curves. As seen, the valence band of mp-TiO₂, SnO₂ NCs, and a-SnO₂ films are 7.92 eV, 8.22 eV, and 8.44 eV, respectively. From the UV-visible data shown in Figure 8b, the band gap of mp-TiO₂, SnO₂ NCs, and a-SnO₂ are 3.3 eV, 4.05 eV, and 4.1 eV, respectively. Based on these values, the band diagrams of devices on mp-TiO₂, mp-TiO₂/SnO₂ NCs, and mp-TiO₂/a-SnO₂ are plotted schematically, as observed in Figure 8c. From the results, it is clear that a-SnO₂ film on mp-TiO₂ facilities charge transfer, which is better than reference cell in terms of having an ohmic contact, while a crystalline layer of SnO₂ on top of mp-TiO₂ works as a blocking layer for carriers, resulting in poor device performance, as proved by *J-V* results earlier. In fact, device based on double layer ETL, *i.e.,* mp-TiO₂/a-SnO₂ shows better charge transfer properties due to lower recombination cites on surface of mp-TiO₂. In addition, this device architecture shows a good quenching effect and band alignment with triple cations perovskite film, resulting in lower charge accumulation at the interface and high V_{oc}. In principle, ETL is determined by the electron extraction ability from the perovskite layer, which plays an important role in determining the V_{OC}. In order to support our results, the intensity modulated photovoltage spectroscopy (IMVS) is measured for devices based on mp-TiO₂ and mp-TiO₂/a-SnO₂, as shown in Figure 9. The results revealed a pronounced phase shift peak at 10 Hz for the mp-TiO₂ samples compared to the mp-TiO₂/a-SnO₂one. This feature is also existed in the mp-TiO₂/a-SnO₂ sample, but its reduction in magnitude suggests that the amorphous SnO₂ layer mitigates its contribution in the carrier lifetime.
The small phase shift peak at 10 Hz for the mp-TiO₂/a-SnO₂structure allowed us to identify the additional time constant at very low frequency (1 Hz) related to the motion of ions inside the perovskite layer. On the other hand, the fastest recombination time constant, generally attributed to the perovskite layer, does not show a significant change as expected. Moreover, the direct comparison of electroluminescence measurements confirmed the capability of the a-SnO₂ treatment in suppressing the nonradiative recombination losses (Figure 10). In fact, the external quantum efficiency (EQE) of mp-TiO₂/a-SnO₂ sample at the same current density (16mA/cm²) is more than the standard mp-TiO₂ structure, reaching approximately 0.5%. Note that this value is comparable with state of the art values.

TiO₂ based-perovskite solar cells are suffered from stability under UV light. It is noteworthy that the device on mp-TiO₂/a-SnO₂ is more stable than mp-TiO₂ based solar cell under continuous UV light. For this experiment, the devices were exposed to UV light and measured after each 3 hours. Figure 11 shows the UV stability of devices on mp-TiO₂ and mp-TiO₂/a-SnO₂ after 60 hours exposure to UV lamp. The PCE of perovskite solar cell based on mp-TiO₂/a-SnO₂ is remained almost 97% of its initial value, while mp-TiO₂ based device shows 18% PCE loss in this condition. This clearly shows that the protection effect from UV through a double layer ETL comprising a mp-TiO₂ modified by a-SnO₂ film.

In conclusion, we have developed a new strategy to enhance the quality of mesoporous (mp)-TiO₂ as an electron transfer layer (ETL) in the perovskite solar cell. A thin layer of amorphous SnO₂(a-SnO₂) was deposited on mp-TiO₂ using solution process. The results show that fabrication of device after modification of ETL by a-SnO₂ is the most effective way to enhance the carrier collection and decrease charge recombination in the perovskite solar cell. Notable, SnO₂ nanocrystal (SnO₂ NC) and crystalline SnO₂ (c-SnO₂) have negative effect on photovoltaic (PV) parameters. By using double layer structure (mp-TiO₂ and a-SnO₂), the power conversion efficiency (PCE) of perovskite solar cell is improved by 6% from 19.14% for pure mp-TiO₂ to 20.4% for double layer mainly due to the enhancement of open circuit voltage (V_{oc}). Our intensity modulated photovoltage spectroscopy (IMVS) and electroluminescence (EL) results are in good agreement with the V_{oc} results. In addition, the device based on double layer mp-TiO₂/a-SnO₂ indicates a good stability under continuous illumination of ultraviolet (UV) lamp with only 3% PCE loss after 60 hours, which is more stable than device on bare mp-TiO₂ with 18% loss.

## Claims

1. An optoelectronic and/or photovoltaic device comprising an electron transport layer (ETL) and a light harvesting layer, wherein the light harvesting layer comprises a metal halide perovskite and is provided on the ETL; and said ETL is a multilayer structure comprising at least two layers of metal oxide, of which layer being in contact with said light harvesting layer comprises an amorphous metal oxide.

2. The optoelectronic and/or photovoltaic device according to claim 1, wherein the amorphous metal oxide is amorphous SnO₂.

3. The optoelectronic and/or photovoltaic device according to any one of the preceding claims further comprising a conducting support layer, n-type semiconductor, a hole transport layer (HTL) and a back contact, wherein the n-type semiconductor is in electric contact with the conducting support layer and the ETL is in electric contact with the n-type semiconductor; the HTL is provided on the light harvesting layer; and the back contact is in electric contact with the HTL.

4. The optoelectronic and/or photovoltaic device according to any one of the preceding claims, wherein the ETL comprises at least one layer comprising an amorphous metal oxide and at least one layer comprising a crystalline mesoporous metal oxide.

5. The optoelectronic and/or photovoltaic device according to any one of the preceding claims, wherein at least one layer comprising an amorphous metal oxide is provided on the layer comprising a crystalline mesoporous metal oxide.

6. The optoelectronic and/or photovoltaic device according to any one of claims 4-5, wherein the crystalline mesoporous metal oxide is selected from mesoporous TiO₂ or mesoporous ZnO.

7. The optoelectronic and/or photovoltaic device according to any one of the preceding claims, wherein the n-type semiconductor comprises a compact metal oxide layer.

8. The optoelectronic and/or photovoltaic device according to claim 7, wherein the n-type semiconductor further comprises a mesoporous metal oxide layer being a surface-increasing scaffold structure provided on the compact metal oxide layer.

9. The optoelectronic and/or photovoltaic device according to any one of the preceding claims, the ETL is provided on the compact metal oxide layer of the n-type semiconductor or on the surface-increasing scaffold structure of the n-type semiconductor.

10. The optoelectronic and/or photovoltaic device according to any one of the preceding claims, wherein the ETL forms a planar structure and the metal halide perovskite infiltrates the ETL.

11. The optoelectronic and/or photovoltaic device according to any one of the preceding claims, wherein the amorphous metal oxide layer has a thickness in the range from 10 nm to 30 nm.

12. The optoelectronic and/or photovoltaic device according to any one of the preceding claims, wherein the metal halide perovskite is selected from a perovskite structure according to any one of formulae (I), (Ia), (Ib), (Ic), (Id), (Ie), (If) and/or (Ig) below:
AA'MX₄ (I)
AMX₃ (Ia)
AA'N_{2/3}X₄ (Ib)
AN_{2/3}X₃ (Ic)
BN_{2/3}X₄ (Id)
BMX₄ (Ie)
(A₁)ₘAA'MX₃ (If)
(A₁)ₘAMX₃ (Ig)
wherein,
- A and A' are organic, monovalent cations being independently selected from primary, secondary, tertiary or quaternary organic ammonium compounds, including N-containing heterorings and ring systems, A and A' having independently from 1 to 60 carbons and 1 to 20 heteroatoms;
- A₁ is an inorganic cation selected from Cs⁺, Rb⁺, K⁺ and m is an integer from 1 to 3, each A₁ if m >1 being different;
- B is an organic, bivalent cation selected from primary, secondary, tertiary or quaternary organic ammonium compounds having from 1 to 60 carbons and 2-20 heteroatoms and having two positively charged nitrogen atoms;
- M is selected from Cu²⁺, Ni²⁺, Co²⁺, Fe²⁺, Mn²⁺, Cr²⁺, pd²⁺, Cd²⁺, Ge²⁺, Sn²⁺, Pb²⁺, Eu²⁺, Yb²⁺, [SnᵢPb₍₁₋ᵢ₎]⁺, [SnⱼGe₍₁₋ⱼ₎]⁺, and [PbₖGe₍₁₋ₖ₎]⁺, i, j and k being a number between 0.0 and 1.0;
- N is selected from the group of Bi³⁺ and Sb³⁺; and,
- X are independently selected from Cl⁻, Br⁻, I⁻, NCS⁻, CN⁻, NCO⁻, from [I₍₃₋ₘ₎Clₘ]⁻, [I₍₃₋ₙ₎Brₙ]⁻, [Br₍₃₋ᵤ₎Clᵤ]⁻, m, n u being a number between 0.0 and 3.0, and from a combination of two anions selected from Cl⁻, Br⁻, I⁻.

13. The optoelectronic and/or photovoltaic device according to any one of the preceding claims, wherein the HTL comprises one or more inorganic p-type semiconductor selected from NiO, CuO, CuSCN, CuI, CuGaO₂, CuCrO₂ or CuAlO₂ or any combination thereof.

14. The optoelectronic and/or photovoltaic device according to any one of claims 1-12, wherein the HTL is selected from triphenylamine, carbazole, N,N,(diphenyl)-N',N'di-(alkylphenyl)-4,4'-biphenyldiamine, (pTPDs), diphenylhydrazone, poly [N,N'-bis(4-butylphenyl)-N,N'-bis(phenyl)benzidine] (polyTPD), polyTPD substituted by electron donor groups and/or acceptor groups, poly(9,9-dioctylfluorene-alt-N-(4-butylphenyl)-diphenylamine (TFB), 2,2',7,7'-tetrakis-N,N-di-p-methoxyphenylamine-9,9'-spirobifluorene) (spiro-OMeTAD), N,N,N',N'-tetraphenylbenzidine (TPD), PTAA (Poly[bis(4-phenyl)(2,4,6-trimethylphenyl)amine]).

15. The optoelectronic and/or photovoltaic device according to any one of the preceding claims is selected from an organic photovoltaic device, a photovoltaic solid state device, a p-n heterojunction, a metal organohalide perovskite photovoltaic device, a metal organohalide perovskite solar cell, a solid state solar cell, a phototransistor and LED (light-emitting diode).
